# EUROPEAN PATENT APPLICATION

(11) **EP 4 733 289 A1**
(43) Date of publication of application: **29.04.2026**
(21) Application number: 23942476.5
(22) Date of filing: 26.06.2023
(51) Int. Cl.: C04B 35/581, C04B 35/80, C04B 35/81, H01L 23/36, H01L 25/07, H01L 25/18, H05K 1/03

(54) **CERAMIC SUBSTRATE, POWER MODULE, AND ALUMINUM NITRIDE SINTERED BODY**

(30) Priority: 21.06.2023 JP 2023101867
(71) Applicant: U-MAP Co., Ltd., Nagoya 4648601 (JP)
(72) Inventor: MATSUMOTO, Masaki, Nagoya 464-8601 (JP); UCHIDA, Kei, Nagoya 464-08601 (JP)
(74) Representative: Mathys & Squire
(86) International application number: PCT/JP2023/023596
(87) International publication number: WO 2024/262048

(57) **Abstract**

The present invention relates to a ceramic substrate having improved flexural strength in addition to thermal conductivity and fracture toughness, and more particularly to a ceramic substrate composed of an aluminum nitride sintered body formed by sintering fibrous aluminum nitride single crystals and particulate aluminum nitride, wherein the maximum minor axis of the aluminum nitride particles comprising the sintered body is 15.0 µm or less as determined from a micrograph of the sintered body.

## Description

### TECHNICAL FIELD

The present invention relates to ceramic substrates, power modules, and an aluminum nitride sintered body, and more particularly to ceramic substrates having excellent thermal conductivity, fracture toughness, and flexural strength.

### BACKGROUND ART

For example, control modules used for power and motor control in electric vehicles, autonomous vehicles, railways, machine tools, data centers, and high-brightness LEDs are modules to which high voltage is applied, and ceramic substrates are used as the substrates for these modules.

It is widely known that a silicon nitride sintered body and an aluminum nitride sintered body are used as ceramic substrates in such control modules. However, when a silicon nitride sintered body are used as ceramic substrates, the low thermal conductivity becomes an issue. Conversely, when an aluminum nitride sintered body are used as ceramic substrates, although they exhibit excellent thermal conductivity, they suffer from reduced fracture toughness.

International Publication No. 2022/030637 (Patent Literature 1) discloses that, for a ceramic substrate composed of an aluminum nitride sintered body, the use of fibrous aluminum nitride single crystals enables the provision of a ceramic substrate that combines both thermal conductivity and mechanical properties such as fracture toughness.

### CITATION LIST

### PATENT LITERATURE

Patent Literature 1: WO2022/030637A

### SUMMARY OF THE INVENTION

### TECHNICAL PROBLEM

The inventors conducted research on ceramic substrates comprising fibrous aluminum nitride single crystals. As a result, it was found that, while ceramic substrates comprising fibrous aluminum nitride single crystals exhibited excellent fracture toughness, they tended to have lower flexural strength, indicating that there remained room for improvement in the mechanical strength of the ceramic substrates.

Accordingly, an object of the present invention is to provide a ceramic substrate having improved flexural strength in addition to high thermal conductivity and fracture toughness. Another object of the present invention is to provide a power module employing such a base material, as well as an aluminum nitride sintered body suitable for use in such ceramic substrates.

### SOLUTION TO PROBLEM

The inventors first observed the microstructures of an aluminum nitride sintered body: one that does not use fibrous aluminum nitride single crystals and another that does. Despite being sintered under identical conditions, the aluminum nitride sintered body that includes fibrous aluminum nitride single crystals exhibited a significantly greater number of large particles in the micrograph compared to the body without such crystals.

During liquid-phase sintering, aluminum nitride particles grow through repeated cycles of dissolution and precipitation. In this process, particles with smaller radii of curvature tend to dissolve more readily, while those with larger radii of curvature are prone to grow-a phenomenon known as Ostwald ripening. Therefore, when fibrous aluminum nitride single crystals are added to particulate aluminum nitride as the raw material and the mixture is sintered, the fibrous single crystals preferentially grow over time, while the smaller particulate aluminum nitride particles dissolve into the aid agent phase. As a result, it is considered that the microstructure of the resulting an aluminum nitride sintered body contains many large particles, which originate from the fibrous aluminum nitride single crystals.

Further investigations by the inventors revealed that, in manufacturing an aluminum nitride sintered body using both fibrous aluminum nitride single crystals and particulate aluminum nitride, the flexural strength can be improved by adjusting the maximum minor axis of the aluminum nitride particles in the final sintered body to be 15.0 µm or less. Moreover, even when the maximum minor axis is limited to this specified range, the thermal conductivity and fracture toughness remain unaffected or, if affected, are only minimally impacted. As a result, it is possible to maintain high thermal conductivity and high fracture toughness. Accordingly, the inventors have completed the present invention, which provides an aluminum nitride sintered body and ceramic substrates featuring excellent thermal conductivity, fracture toughness, and flexural strength.

Therefore, the ceramic substrate of the present invention comprises an aluminum nitride sintered body formed by sintering a mixture of fibrous aluminum nitride single crystals and particulate aluminum nitride. A distinctive feature is that the maximum minor axis of the aluminum nitride particles in the microstructure of the sintered body is 15.0 µm or less.

In a preferred embodiment of the ceramic substrate of the present invention, the voids present in the sintered body each have a maximum dimension of 2.5 µm or less, as measured by the longest straight-line distance between any two points on the outer perimeter of the void in the micrograph of the sintered body.

In another preferred embodiment of the ceramic substrate of the present invention, the thermal conductivity of the ceramic substrate is in the range of 175 to 183 W/mK.

In another preferred embodiment of the ceramic substrate of the present invention, the fracture toughness, as measured by the SEPB method, satisfies a value of 4.2 to 5.8 MPa·m^{1/2} in at least one fracture direction.

In another preferred embodiment of the ceramic substrate of the present invention, the flexural strength of the ceramic substrate is in the range of 306 to 344 MPa.

In another preferred embodiment of the ceramic substrate of the present invention, the thermal conductivity is in the range of 175 to 183 W/mK, the fracture toughness, as measured by the SEPB method, satisfies a value of 4.2 to 5.8 MPa·m^{1/2} in at least one fracture direction, and the flexural strength is in the range of 306 to 344 MPa.

In another preferred embodiment of the ceramic substrate of the present invention, the oxygen content in the ceramic substrate is 2.8 mass% or less.

Further, the power module of the present invention is a power module comprising the above-described ceramic substrate of the present invention.

Further, the aluminum nitride sintered body of the present invention are an aluminum nitride sintered body formed by sintering fibrous aluminum nitride single crystals and particulate aluminum nitride, characterized in that the maximum minor axis of the aluminum nitride particles in the micrograph of the sintered body is 15.0 µm or less.

### EFFECT OF INVENTION

According to the ceramic substrate of the present invention, it is possible to provide a ceramic substrate exhibiting excellent thermal conductivity, fracture toughness, and flexural strength. Furthermore, according to the power module of the present invention, a power module employing such a ceramic base material can be provided. Additionally, according to the aluminum nitride sintered body of the present invention, an aluminum nitride sintered body suitable for use in such a ceramic substrate can be provided.

### BRIEF DESCRIPTION OF DRAWINGS

Fig. 1 is a perspective view schematically illustrating the crystal structure of a fibrous aluminum nitride single crystal.
Fig. 2 is a schematic diagram showing an example configuration of an apparatus for performing X-ray diffraction on the ceramic substrate.
Fig. 3 is a schematic diagram illustrating an example configuration of a power module.
Fig. 4 is a micrograph of the aluminum nitride sintered body for Sample No. 2.
Fig. 5 is a graph showing the "Flexural Strength (MPa)" values from Table 1 on the vertical axis and the "Maximum Minor Axis (µm)" values on the horizontal axis, plotting the measurement results for Samples No. 1 to No. 8.
Fig. 6 is a graph showing the "Maximum Pore Diameter (µm)" values from Table 1 on the vertical axis and the "Flexural Strength (MPa)" values on the horizontal axis, plotting the measurement results for Samples No. 1 to No. 8.
Fig. 7 is a schematic diagram and dimensional drawing of the sample used for the cold-heat cycle test.
Fig. 8 shows the results of the cold-heat cycle test.

### DESCRIPTION OF EMBODIMENTS

The present invention will now be described in detail. This invention relates to a ceramic substrate, a power module comprising said ceramic substrate, and an aluminum nitride sintered body suitable for use in said ceramic substrate.

In this specification, a "ceramic substrate" refers to a substrate composed of sintered body of inorganic compounds such as aluminum nitride, silicon nitride, alumina, alumina-zirconia, beryllium oxide, or the like. For practical applications, ceramic substrates are required to exhibit, depending on the intended use, favorable properties such as high thermal conductivity, insulating performance, heat resistance, and mechanical strength. Ceramic substrates are mainly used in power modules.

In this specification, a "power module" refers to a module used for power or motor control in devices such as light-emitting diodes, laser diodes, electric vehicles, autonomous vehicles, railways, machine tools, data centers, industrial robots, solar power generation systems, wind power generation systems, uninterruptible power supplies (UPS), semiconductor manufacturing equipment, and the like.

In this specification, an "aluminum nitride sintered body" mean a densified material obtained by adding a sintering aid to powdered aluminum nitride and subsequently firing it. In the present invention, fibrous aluminum nitride single crystals are additionally sintered with the above raw materials. Aluminum nitride may also be denoted as AlN.

The ceramic substrate of the present invention is a substrate comprising an aluminum nitride sintered body and the sintered body is formed by sintering fibrous aluminum nitride single crystals together with particulate aluminum nitride. By adding fibrous aluminum nitride single crystals to particulate aluminum nitride, it is possible to achieve both high thermal conductivity and high fracture toughness in the resulting aluminum nitride sintered body, as well as in the ceramic substrate made from this sintered body. In this specification, this an aluminum nitride sintered body may also be referred to as "the aluminum nitride sintered body of the present invention." Although the aluminum nitride sintered body of the present invention are particularly well suited for ceramic substrates, it may also be used in, for example, components for semiconductor manufacturing equipment, ceramic heaters, electrostatic chucks, Peltier elements, and other applications.

A fibrous aluminum nitride single crystal may also be referred to as a fiber-like aluminum nitride single crystal. In other words, "fibrous" means that the AlN single crystal is formed in an elongated, fiber-like configuration. The overall shape only needs to be fibrous; for example, the crystal may extend in a straight line, or some parts may be curved or bent.

The fibrous aluminum nitride single crystal possesses a high aspect ratio. The aspect ratio of such a crystal is preferably in the range of 2 to 100, and more preferably from 5 to 50. The aspect ratio is defined as the ratio of the median diameter of the major axis to the median diameter of the minor axis (major axis median diameter / minor axis median diameter) of the fibrous aluminum nitride single crystal, as described below.

The median diameter of the major axis of the fibrous aluminum nitride single crystal is preferably from 5 to 100 µm, and more preferably from 10 to 50 µm. The median diameter of the minor axis of the fibrous aluminum nitride single crystal is preferably from 1 to 3 µm, and more preferably from 1 to 2 µm.

In this specification, the median diameter of the major axis and the median diameter of the minor axis of the fibrous aluminum nitride single crystal can be determined from microscopic images obtained using an optical microscope. Specifically, at least 5,000 fibrous aluminum nitride single crystals are selected from the microscopic image. The maximum length of each fiber is defined as the major axis, and the maximum length measured perpendicular to the major axis is regarded as the minor axis. Based on these measurements, a cumulative volume-based distribution is created, and the diameter at which the cumulative percentage reaches 50% is taken as the median diameter for both the major and minor axes. The median diameters of the major and minor axes can be measured using, for example, the "PITA-04" particle shape image analysis system manufactured by Seishin Enterprise Co., Ltd.

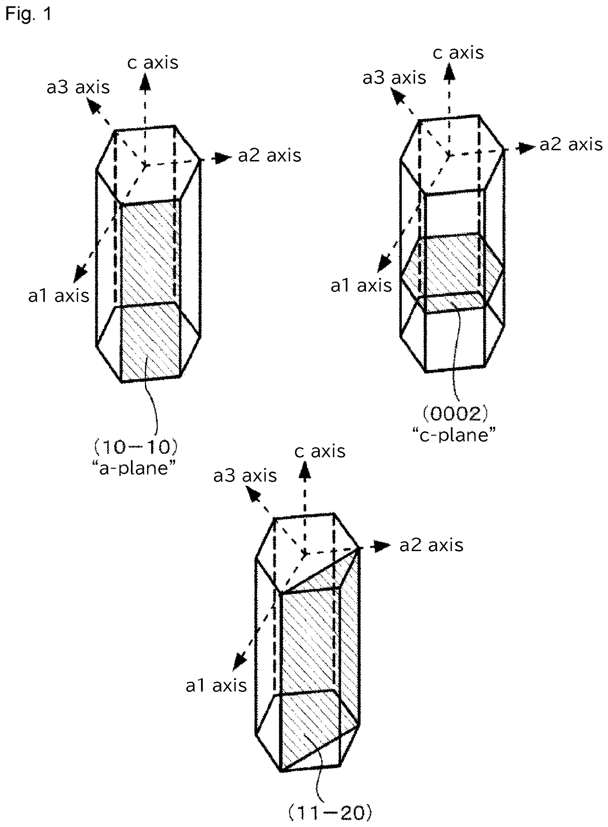

The fibrous aluminum nitride single crystal, as illustrated in Figure 1, adopts a so-called hexagonal wurtzite-type crystal structure. This fibrous aluminum nitride single crystal has (10-10), (0002), and (11-20) crystal faces. The (10-10) and (11-20) faces are examples of faces extending along the longitudinal direction of the fibrous aluminum nitride single crystal, while the (0002) face is an example of a face perpendicular to the longitudinal direction. Hereinafter, the (10-10) face will be referred to as the "a-plane" and the (0002) face as the "c-plane".

The orientation of particles based on fibrous aluminum nitride single crystals (*i.e.*, particles having an elevated aspect ratio grown from such crystals as a nucleus) in the aluminum nitride sintered body of the ceramic substrate is not particularly limited. Those particles may be oriented, for example, along the plate thickness direction of the ceramic substrate, along a direction perpendicular to the plate thickness, or may include a combination of both orientations.

Since the fibrous aluminum nitride single crystals maintain the hexagonal wurtzite structure even after sintering (that is, particles based on such crystals comprising the aluminum nitride sintered body retain the same structure), the orientation of these particles within the ceramic substrate can be evaluated using X-ray diffraction.

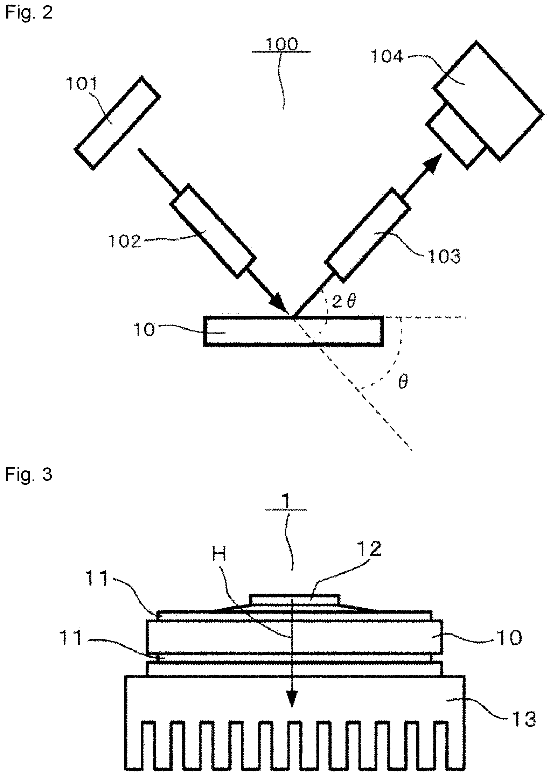

Figure 2 schematically shows an example of an apparatus for performing X-ray diffraction on the ceramic substrate. The X-ray diffraction apparatus 100 comprises an X-ray source 101, an incident-side collimator 102, a light receiving side collimator 103, and a detector 104. X-rays emitted by the X-ray source 101 are directed, through incident-side collimator 102, to an end face of the ceramic substrate 10 (specifically, a face perpendicular to the plate thickness direction). The X-rays diffracted by the substrate pass through the light receiving side collimator 103 and reach the detector 104, which then measures the resulting diffraction pattern.

In such X-ray diffraction measurements using the X-ray diffractometer 100, by varying the angle 2θ of the detector 104 relative to the direction of the incident X-rays (for example, in a range from 20 degrees to 80 degrees), diffraction peaks corresponding to the various crystal faces of the hexagonal wurtzite structure, such as the "a-plane" and "c-plane," can be obtained. Furthermore, the peak intensity obtained by X-ray diffraction corresponds to the maximum count on each face of the hexagonal wurtzite structure within the ceramic substrate, which also indicates the population of each face present.

As described in International Publication No. 2022/030637, the peak value corresponding to the "a-plane," *i.e.*, the (10-10) plane, in the X-ray diffraction pattern obtained when X-rays are irradiated onto the end face of the ceramic substrate 10 in the plate thickness direction is typically detected when the angle of the detector 104 is approximately 33.21 degrees. However, the peak corresponding to the "a-plane" (the (10-10) plane) may sometimes be detected at an angle slightly different from approximately 33.21 degrees, depending, for example, on the shape of the sample or the positional relationships within the apparatus.

Similarly, the peak value corresponding to the "c-plane," *i.e.*, the (0002) plane, in the X-ray diffraction pattern obtained by irradiating X-rays onto the end face in the plate thickness direction of ceramic substrate 10 is detected when the angle of detector 104 is approximately 36.04 degrees. However, the peak for the "c-plane" (the (0002) plane) may also be detected at an angle slightly different from approximately 36.04 degrees, depending, for example, on factors such as the shape of the sample or the arrangement of components in the apparatus.

Furthermore, when the peak intensity ratio for the "a-plane" *(i.e.,* the (10-10) plane) in the X-ray diffraction pattern, obtained by irradiating X-rays onto the end face in the plate thickness direction of the ceramic substrate, is larger, and the peak intensity ratio for the "c-plane" *(i.e.,* the (0002) plane) is smaller compared to a ceramic substrate not containing fibrous aluminum nitride single crystals, it can be inferred that the particles based on fibrous aluminum nitride single crystals in that ceramic substrate are oriented along a direction perpendicular to the plate thickness direction.

Furthermore, the ratio of the peak intensity of the "a-plane" to that of the "c-plane" in the X-ray diffraction pattern obtained by X-ray diffraction of the ceramic substrate (the a/c value) is interpreted as follows: a higher a/c value indicates stronger orientation of the particles, based on fibrous single-crystal aluminum nitride within the ceramic substrate, along the end surface direction of the plate thickness; or alternatively, a higher a/c value indicates a greater amount of particles based on fibrous aluminum nitride single crystals contained within the ceramic substrate.

X-ray diffraction is performed using the well-known 0-2θ method, for example, with the "Ultima IV" X-ray diffractometer manufactured by Rigaku Corporation. The measurement conditions of X-ray diffraction are as follows: voltage: 40 kV; current: 30 mA; divergence slit: 1/2 degree; scattering slit: 1/2 degree; light receiving slit: 0.3 mm; scan step: 0.02 degrees; and 2θ scan range: 20 to 80 degrees. The peak positions in the X-ray diffraction pattern can be determined based on the AlN X-ray spectrum available in the "AtomWork" inorganic materials database of the National Institute for Materials Science (NIMS). The peak intensity in the X-ray diffraction pattern corresponds to the maximum count value for each peak.

It is preferable that at least a portion of the surface of the fibrous aluminum nitride single crystal is coated with an oxygen-containing layer. By coating the surface of the fibrous AlN single crystal with an oxygen-containing layer, its water resistance can be improved. The oxygen-containing layer is formed during the manufacturing process of the AlN single crystal, as the single crystal incorporates at least oxygen atoms. When AlN reacts with oxygen molecules or water molecules, an oxygen-containing layer comprising at least one of Al₂O₃, AlON, and Al(OH)₃ can be formed to cover the surface of the AlN single crystal. From the viewpoint of improved water resistance, it is preferable that the oxygen-containing layer includes AlON.

In this specification, a fibrous aluminum nitride single crystal whose surface is coated with an oxygen-containing layer is referred to as an "aluminum nitride whisker" or "AlN whisker."

The oxygen content in the aluminum nitride whisker is preferably 3.0 mass% or less, more preferably 2.0 mass% or less, and most preferably 1.0 mass% or less. The lower the oxygen content in the aluminum nitride whisker, the better. However, oxygen may be unavoidably present due to the manufacturing process or other factors. In such cases, from the perspective of manufacturing costs and the like, it is preferable for the oxygen content in the aluminum nitride whisker to be at least 0.01 mass% as a lower limit.

The oxygen content in the aluminum nitride whisker can be measured using, for example, the "EMGA-920" analyzer manufactured by HORIBA, Ltd. Specifically, the oxygen content may be measured as follows: about 10 mg of sample is packed into a nickel capsule and placed into the instrument. The sample is then decomposed by pyrolysis, and the released oxygen is reacted with a carbon catalyst to form carbon monoxide, which is subsequently analyzed.

Methods for producing fibrous aluminum nitride single crystals and aluminum nitride whiskers are already known, and are described in detail, for example, in Japanese Patent Application Publication No. 2018-154534.

The amount of fibrous aluminum nitride single crystals used in the production of the aluminum nitride sintered body is preferably 1 to 30 parts by mass per 100 parts by mass of the particulate aluminum nitride matrix, and more preferably 3 to 5 parts by mass.

The particulate aluminum nitride serves as the matrix material for the aluminum nitride sintered body and has a small aspect ratio of 1.1 or less. The aspect ratio is determined as the ratio of the median diameter of the major axis to the median diameter of the minor axis (major axis median diameter / minor axis median diameter).

The median diameter of both the major and minor axes of the particulate aluminum nitride is preferably in the range of 0.3 to 5 µm, and more preferably in the range of 0.5 to 3 µm.

In this specification, the median diameters of the major and minor axes of the particulate aluminum nitride are determined from optical microscopic images. Specifically, at least 5,000 particles are selected from the image. For circular particles, the diameter is taken as both the major and minor axes; for non-circular particles, the maximum length is defined as the major axis and the maximum length in the direction perpendicular to the major axis as the minor axis. Based on these measurements, a cumulative volume-based distribution is constructed, and the diameter at which the cumulative proportion reaches 50% for each axis is taken as the median diameter. The median diameters can be measured using, for example, the PITA-04 particle shape image analysis system manufactured by Seishin Enterprise Co., Ltd.

The oxygen content in the particulate aluminum nitride is preferably 2.0 mass% or less, more preferably 1.0 mass% or less, and most preferably 0.5 mass% or less. The lower the oxygen content, the better. However, oxygen may be unavoidably present due to the manufacturing process, etc. In such cases, the oxygen content is preferably at least 0.01 mass%. The method for measuring the oxygen content is the same as that described above for measuring the oxygen content in aluminum nitride whiskers.

In addition to aluminum nitride, materials used for manufacturing the aluminum nitride sintered body may include additional components such as sintering aids, dispersants, defoamers, organic solvents, and water. These components can be appropriately used according to the desired purpose.

Sintering aids are often used in the manufacture of an aluminum nitride sintered body. Examples of sintering aids include oxides of rare earth elements, oxides of alkaline earth elements, carbonates, oxalates, and nitrates. Among these, oxides of rare earth elements are preferred, with yttria (Y₂O₃) being particularly preferred.

When a sintering aid is used, the amount is preferably 1 to 10 parts by mass per 100 parts by mass of particulate aluminum nitride, which serves as the base material, and more preferably 3 to 7 parts by mass.

The maximum minor axis of the aluminum nitride particles comprising the aluminum nitride sintered body is preferably 15.0 µm or less as viewed in a micrograph of the sintered body, more preferably 13.0 µm or less, and still more preferably 12.0 µm or less. According to the present invention, by controlling the maximum minor axis of the aluminum nitride particles within the specified range, the flexural strength of the aluminum nitride sintered body and the ceramic substrate produced from it can be improved. The smaller the maximum minor axis of the aluminum nitride particles, the better. However, from the standpoint of manufacturing and handling, the lower limit is preferably 1.0 µm or more. Furthermore, an aluminum nitride sintered body in which the maximum minor axis of the aluminum nitride particles is within the specified range exhibit thermal conductivity and fracture toughness values comparable to those of an aluminum nitride sintered body where the maximum minor axis exceeds 15.0 µm. Therefore, the aluminum nitride sintered body and the ceramic substrate of the present invention can provide excellent thermal conductivity, fracture toughness, and flexural strength.

The reason why the aluminum nitride sintered body of the present invention achieve thermal conductivity comparable to that of conventional an aluminum nitride sintered body while maintaining superior flexural strength is believed to be that thermal conductivity is largely determined by the oxygen content within the grains. As sintering proceeds and the grains grow, the oxygen inside the grains is also expelled from the system. As a result, in general, particles with a larger maximum minor axis exhibit higher thermal conductivity since longer sintering allows more oxygen depletion. In other words, there is a spurious correlation between maximum minor axis and thermal conductivity. In the present invention, by adding fibrous aluminum nitride single crystals with large curvature radii to the particulate aluminum nitride matrix, these fibrous single crystals selectively grow rapidly in a short time. This accelerates the removal of oxygen from the grains, enabling higher thermal conductivity to be achieved while suppressing grain growth.

The reason the aluminum nitride sintered body of the present invention achieves fracture toughness comparable to that of conventional an aluminum nitride sintered body with larger maximum minor axis of aluminum nitride particles is that, in general, for ceramics with a uniform microstructure, a larger grain size results in higher fracture toughness. Fracture toughness is a parameter that indicates resistance to crack propagation. In an aluminum nitride sintered body, cracks propagate along grain boundaries. When the particles are larger, cracks tend to circumvent the grains, thus improving the fracture toughness. In the aluminum nitride sintered body of the present invention, the addition of fibrous aluminum nitride single crystals causes frequent crack deflection (bridging effect), thereby enabling high fracture toughness to be achieved regardless of grain size.

Here, the aluminum nitride particles comprising the aluminum nitride sintered body refer to those formed during the grain growth process in sintering. Particles with a high aspect ratio, grown from fibrous aluminum nitride single crystals as nuclei, are distributed within the matrix of granular (particulate) aluminum nitride grown through repeated dissolution and precipitation.

In this specification, the "micrograph of the aluminum nitride sintered body" used to determine the maximum minor axis of the aluminum nitride particles comprising the sintered body and also to determine the size of voids present in the aluminum nitride sintered body, as described later-refers to an electron microscope image taken with a scanning electron microscope (SEM). To distinguish between individual grains, a backscattered electron (BSE) image is used, which shows contrast differences depending on the orientation of the crystalline particles. The micrograph should include at least 200 aluminum nitride particles. Because the aluminum nitride sintered body typically have a relatively homogeneous structure, a micrograph of a given region containing at least 200 particles can be considered representative. Therefore, by observing just one such micrograph *(i.e.,* one field of view), it is possible to determine whether it meets the configuration requirements of the present invention. It should also be noted that, depending on the manufacturing method, a small number of coarse aluminum nitride grains or coarse voids may inevitably occur in the aluminum nitride sintered body; however, the presence of a small quantity of such coarse particles or voids has no significant impact on the properties of the sintered body. In this specification, images were taken under the following conditions: accelerating voltage of 3-5 keV, current of 20 µA, and working distance of 4 mm. In order to avoid surface irregularities from appearing as contrast, the sample surface was polished and then processed by ion milling or a similar technique to achieve a surface roughness Ra of less than approximately 0.2 µm. Ra indicates arithmetic mean roughness and can be measured in accordance with JIS B 0601 (2013).

In this specification, the minor axis of the aluminum nitride particles comprising the aluminum nitride sintered body is defined as the maximum length in the direction perpendicular to the major (long) diameter, where the major diameter is the maximum straight-line distance between two points on the particle's circumference. In the case of circular aluminum nitride particles, the diameter is taken as the minor axis. The maximum minor axis of the aluminum nitride particles refers to the largest value of the minor axis of all the particles within the micrograph of the aluminum nitride sintered body.

In the present invention, methods for adjusting the maximum minor axis of the aluminum nitride particles comprising the aluminum nitride sintered body to 15.0 µm or less include, for example, controlling the firing temperature and firing time during the sintering process. Specifically, by setting relatively low firing temperatures and shorter firing times for the fibrous aluminum nitride single crystals and the particulate aluminum nitride, an aluminum nitride sintered body comprising particles with small maximum minor axis and in the range of 15.0 µm or less can be obtained. Furthermore, by using fine metallic materials as raw materials, the pinning effect can be employed to control grain growth and thus adjust the maximum minor axis.

Voids may form between the aluminum nitride particles comprising the aluminum nitride sintered body. In the present invention, it is preferable that the maximum straight-line distance between any two points on the perimeter of each void observed in the micrograph of the sintered bodies 2.5 µm or less, and more preferably 1 µm or less. Since voids in the aluminum nitride sintered body can act as initiation sites for fracture, it is desirable to minimize large voids. Even in cases where voids are elongated in a particular direction (such as line-shaped voids), these can also become fracture initiation sites. Therefore, it is preferable to control the maximum straight-line length between two points on the perimeter of a void in the micrograph of the sintered body. According to the present invention, because the particle size of the aluminum nitride particles is small, it is possible to minimize the voids that may occur between particles. If minimizing voids is technically challenging, a lower limit of 0.1 µm or more for the maximum straight-line length is preferable.

The thermal conductivity of the ceramic substrate is preferably in the range of 170 to 250 W/mK, more preferably 170 to 230 W/mK, even more preferably 170 to 220 W/mK, and particularly preferably 175 to 183 W/mK. This preferred range also applies to the thermal conductivity of the aluminum nitride sintered body of the present invention. Although higher thermal conductivity is generally desirable, in view of the significant increase in production costs required for extremely high conductivity, it is preferred that the thermal conductivity be 220 W/mK or less.

In this specification, thermal conductivity is measured by the hot disc method in accordance with ISO 22007-2 "Plastics-Determination of thermal conductivity and thermal diffusivity-Part2:Transient plane heat source(hot disc)method". For example, a "TPS-2500" instrument manufactured by Kyoto Electronics Manufacturing Co., Ltd. can be used.

In this specification, fracture toughness is measured by the SEPB (Single Edge Pre-cracked Beam) method in accordance with JIS R1607, "Room Temperature Fracture Toughness Test Method for Fine Ceramics". For example, a Mitutoyo micrometer, Mitutoyo Vickers hardness tester (HV-115), Instron universal testing machine (model 5582), and Nikon MEASURESCOPE 10 and others may be used.

When particles having a predetermined aspect ratio and formed by grain growth on fibrous AlN single-crystal nuclei (hereinafter also referred to simply as "fibrous particles") are oriented in the plane, the fracture toughness of the ceramic substrate of the present invention varies depending on the in-plane orientation of the fibrous particles. For example, when two specimens differing only in the orientation of the fibrous particles are measured using the SEPB method, the specimen with fibrous particles being oriented parallel to the direction of fracture may show a fracture toughness of 4.1 MPa·m^{1/2}, while the specimen with fibrous particles being oriented crossing to the fracture direction may show a fracture toughness of 6.1 MPa·m^{1/2}. In general, specimens in which the fibrous particles are oriented crossing to the direction of fracture tend to have higher fracture toughness. The "direction of fracture in the SEPB method" refers to the plate thickness direction of the specimen, starting from the surface where the crosshead is applied during measurement, indicating the direction in which the crack propagates.

The fracture toughness of the ceramic substrate, as measured by the SEPB method, is preferably in the range of 2.5 to 10.0 MPa·m^{1/2} in at least one fracture direction, more preferably 3.5 to 7.0 MPa·m^{1/2}, and more preferably 4.2 to 5.8 MPa·m^{1/2}. These preferred ranges for the ceramic substrate likewise apply to the fracture toughness of the aluminum nitride sintered body of the present invention.

The flexural strength of the ceramic substrate is preferably 250 to 450 MPa, more preferably 300 to 450 MPa, and particularly preferably 306 to 344 MPa. These preferred ranges for the ceramic substrate also apply to the flexural strength of the aluminum nitride sintered body of the present invention.

In this specification, the flexural strength is measured in accordance with JIS R1601 "Room Temperature Flexural Strength Test Method for Fine Ceramics," using the SEPB method. For example, an Autograph AGX-10KNVV universal testing machine manufactured by Shimadzu Corporation may be used.

In a preferred embodiment of the present invention, the ceramic substrate and the aluminum nitride sintered body have a thermal conductivity of 170 to 220 W/mK, a fracture toughness of 4 to 8 MPa·m^{1/2}, in at least one fracture direction as measured by the SEPB method, and a flexural strength of 300 to 450 MPa. In a further preferred embodiment, the ceramic substrate and the aluminum nitride sintered body have a thermal conductivity of 175 to 183 W/mK, a fracture toughness of 4.2 to 5.8 MPa·m^{1/2}, in at least one fracture direction as measured by the SEPB method, and a flexural strength of 306 to 344 MPa.

The oxygen content in the ceramic substrate is preferably 3 mass% or less, and more preferably 2.8 mass% or less. These preferred values similarly apply to the oxygen content in the aluminum nitride sintered body of the present invention. In general, the lower the oxygen content in both the ceramic substrate and the aluminum nitride sintered body, the better. However, if oxygen inclusion is unavoidable during manufacturing, the oxygen content in the ceramic substrate is preferably at least 0.01 mass%.

In this specification, the oxygen content of the ceramic substrate can be measured using, for example, the "EMGA-920" analyzer manufactured by HORIBA, Ltd. Specifically, the oxygen content can be measured as follows: Approximately 10 mg of the sample is filled into a nickel capsule and introduced into the device. The sample is then decomposed by pyrolysis, and the oxygen is reacted with carbon using a catalyst to form carbon monoxide, which is then analyzed. As a pretreatment, the ceramic substrate is pulverized using, for example, an alumina mortar. After pulverization, coarse particles are removed using a 77 µm mesh sieve, and the measurement is then carried out.

The ceramic substrate preferably has a density of 3.26 to 3.31 g/cm³, and more preferably 3.28 to 3.31 g/cm³. This preferred density range for the ceramic substrate also applies to the density of the aluminum nitride sintered body of the present invention. In this specification, density refers to the value measured by the liquid displacement (Archimedes) method, in accordance with JIS Z 8807 "Methods for Determining the Density and Specific Gravity of Solids."

The ceramic substrate preferably has a thickness of 0.1 to 1.5 mm. This preferred thickness range for the ceramic substrate similarly applies to the plate thickness of the aluminum nitride sintered body of the present invention.

Next, the method for manufacturing the ceramic substrate will be described. The method for manufacturing the ceramic substrate generally includes a kneading step, a molding (forming) step, a degreasing step, and a sintering step. The manufacturing method may also include a drying step after the kneading step or a granulation step before the molding step. It should be noted that the manufacturing method for the ceramic substrate described here can also be regarded as a manufacturing method for the aluminum nitride sintered body.

The kneading step involves mixing the materials used for manufacturing the ceramic substrate to prepare a slurry. For example, a mixture of dispersant and organic solvent is prepared, and fibrous aluminum nitride single crystals are added and dispersed in it. Subsequently, a sintering aid and particulate aluminum nitride, which is used as the base material, are added and kneaded. In this way, the slurry is prepared.

The drying step may be carried out after the kneading step when there is a large amount of solvent in the slurry. This step removes the solvent from the slurry and adjusts the concentration of aluminum nitride in the slurry. The drying conditions for the slurry are not particularly limited; for example, drying may be carried out at a temperature of 130 °C and a pressure of -0.1 MPa for a predetermined time, such as about one hour. For the subsequent steps (such as granulation or forming), it is preferable that the aluminum nitride content in the slurry be 20 to 70 mass %.

The granulation step may be performed to make molding easier, and involves forming the slurry, after the kneading step, into granules. The granulation step can be carried out after the kneading step using methods such as spray drying, or after the drying step using, for example, a pot mill.

The forming (molding) step shapes the materials to be used in the manufacture of the ceramic substrate. In this step, either the slurry obtained from the kneading or drying step, or granules produced by the granulation step, may be molded. Suitable forming methods can be selected according to the required shape, application, and size, and examples include die pressing, rubber pressing, slip casting, and sheet forming. For example, a sheet-shaped green body can be obtained by feeding the slurry prepared in the kneading step into a doctor blade-type sheet forming machine. By stacking a specified number of these sheets and pressing them with a hot isostatic press, a plate-shaped green body can be obtained. At this time, the fibrous aluminum nitride single crystals are oriented along the coating direction during sheet forming. Laminating the sheets in the same orientation yields a plate-shaped green body oriented in a single direction; alternatively, laminating in arbitrary directions creates a plate-shaped green body with randomly oriented grains in the horizontal direction. Particles with an aspect ratio, grown from fibrous aluminum nitride single crystal nuclei, tend to become oriented in a direction perpendicular to the plate thickness of the ceramic substrate.

The degreasing step removes organics (such as dispersants) from the materials used to manufacture the ceramic substrate. When dispersants and the like are used, degreasing is usually performed after the forming step. This step can be conducted in, for example, a nitrogen or air (atmospheric) atmosphere. The degreasing temperature is typically 400 to 650 °C, and the degreasing time is generally 4 to 24 hours.

The sintering step densifies the powdery aluminum nitride (particulate aluminum nitride and fibrous aluminum nitride single crystals) by firing, thereby obtaining the aluminum nitride sintered body. Firing is preferably performed in a nitrogen atmosphere. Either atmospheric-pressure or pressure sintering may be used, but atmospheric-pressure sintering is preferable for reasons of economy. In the present invention, it is important to set the firing temperature relatively low and the firing time relatively short in order to adjust the maximum minor axis of the aluminum nitride particles comprising the sintered body to within 15.0 µm or less. The firing temperature is preferably 1800 to 1900 °C, more preferably 1800 to 1850 °C. The firing time is preferably 2 to 24 hours, and more preferably 3 to 15 hours.

Next, the power module of the present invention will be described. The power module of the present invention is a power module that incorporates the ceramic substrate described above, and an embodiment thereof is shown in Figure 3.

The power module 1 illustrated in Figure 3 is an example of a control module used for power control or motor control in applications such as light-emitting diodes, laser diodes, electric vehicles, autonomous vehicles, railways, machine tools, data centers, industrial robots, solar power generation, wind power generation, uninterruptible power supplies (UPS), and semiconductor manufacturing equipment. This power module is equipped with the ceramic substrate 10 of the present invention. The ceramic substrate 10 is formed in a platelike shape, and metal layers 11 are provided on both surfaces in the plate thickness direction. In addition, a so-called power semiconductor 12 is provided on one end surface (the upper surface in Figure 3) of the ceramic substrate 10 in the plate thickness direction. Furthermore, on the other end surface (the lower surface in Figure 3) of the ceramic substrate 10 in the plate thickness direction, a heat sink 13 with a heat dissipation function is provided.

As illustrated by arrow H in Figure 3, the heat generated by the power semiconductor 12 is transferred to the heat sink 13 through the ceramic substrate 10, thereby facilitating heat dissipation from the power module 1.

### EXAMPLES

The present invention will be described in further detail below with reference to examples; however, the invention is not limited to the examples described below.

### 1.Kneading Process

Particulate aluminum nitride (Tokuyama, H grade) was mixed with appropriate amounts of an organic solvent, a dispersant, and a defoaming agent. To this particulate aluminum nitride, fibrous aluminum nitride single crystals (U-MAP, short fiber-crushed type) were added. The particulate aluminum nitride single crystals used had a median minor axis of 1.0 µm, a median major axis of 1.0 µm, an aspect ratio of 1, and an oxygen content of 1.1 mass%. The fibrous aluminum nitride single crystals used had a median minor axis of 2.5 µm, a median major axis of 20 µm, an aspect ratio of 8, and an oxygen content of 2.8 mass%. Yttrium oxide (Nippon Yttrium, fine powder, 3N) was added as a sintering aid. Kneading was performed for 24 hours using a ball mill, thus obtaining a slurry.

For each sample, Table 1 shows the percentage by mass of the fibrous aluminum nitride single crystal in the raw material and the percentage by mass of the sintering aid in the raw material.

### 2. Forming Process

The slurry obtained from the kneading process was shaped into a 100 µm thick sheet by sheet forming. At this stage, because the fibrous AlN single crystals become aligned in the sheet forming direction, separately prepared sheets cut into 50 mm squares were stacked in alternating orientations by rotating every other layer by 90 degrees. This laminated the sheets such that the fibrous AlN single crystals were oriented crosswise in the plane of the sheets. The resulting laminate was then hot-pressed to obtain a molded body with a thickness of 4.5 mm.

### 3. Degreasing Process

The molded body obtained in the forming process was subjected to degreasing. The molded body was placed on a ceramic setter and left stationary inside the furnace. The temperature was raised to 470 °C at a rate of 40 °C/h under atmospheric conditions, held for 4 hours, and then cooled by furnace cooling, thereby obtaining a degreased body.

### 4. Sintering Process

The degreased body obtained from the degreasing process were sintered using a reduction atmosphere furnace. Inside the furnace, which was surrounded by carbon-based thermal insulation, a boron nitride jig was installed, and the degreased body was placed on top of it. Additional boron nitride jigs and degreased bodies were stacked above as necessary. To prevent warping of the degreased bodies, a boron nitride jig and an aluminum nitride substrate were placed on the uppermost tier as weights. After nitrogen purging, the temperature was raised at 20 °C/min, and, upon reaching the designated holding temperature, the temperature was maintained for a specified period before cooling. In this way, a ceramic substrate was produced.
Table 1 shows the holding temperature and holding time for each sample. Here, the holding temperature and holding time are referred to as the firing temperature and firing time.

### 5. Characteristics of the Ceramic Substrate

The ceramic substrates obtained through the sintering process had a sintered skin, which was removed by cutting, polishing, and grinding. After removing the sintered skin, the samples (ceramic substrates) were cut to the sizes required for the measurement methods described above, and various properties were measured. For fracture toughness, measurements using the SEPB method were conducted in directions where fibers were oriented perpendicular to the direction of fracture propagation. The results are shown in Table 1.

**TABLE 1**

| Sample No. | Addition Amount of a Sintering Aid (mass %) | Addition Amount of a Fiber (mass %) | Holding Temperature (°C) | Holding Time (°C) | Density (g/cm³) | Thermal Conductivity (W/mK) | Fracture Toughness (MPa·m^{1/2}) | Flexural Strength (MPa) | Oxygen Content (mass %) | Maximum Pore Diameter (µm) | Maximum Minor Axis (µm) |
|---|---|---|---|---|---|---|---|---|---|---|---|
| 1 | 5 | 0 | 1850 | 3 | 3.314 | 172 | 2.9 | 505 | 2.6 | 2.2 | 5.3 |
| 2 | 5 | 5 | 1850 | 3 | 3.285 | 182 | 5.8 | 344 | 2 | 1 | 11.4 |
| 3 | 5 | 5 | 1850 | 6 | 3.284 | 180 | 6.6 | 215 | 2.2 | 3.1 | 15.3 |
| 4 | 5 | 5 | 1850 | 9 | 3.262 | 185 | 6 | 201 | 1.8 | 1.4 | 18.5 |
| 5 | 5 | 5 | 1850 | 12 | 3.26 | 189 | 5.3 | 199 | 2.2 | 3 | 16.7 |
| 6 | 5 | 5 | 1850 | 15 | 3.221 | 190 | 5.7 | 202 | 1.7 | 4.4 | 17.6 |
| 7 | 5 | 1 | 1850 | 3 | 3.309 | 175 | 4.2 | 360 | 2.3 | 2.1 | 12.5 |
| 8 | 5 | 3 | 1850 | 3 | 3.305 | 183 | 4.9 | 306 | 2.8 | 2.1 | 12.1 |

In the table, "Sintering Aid Addition Amount (mass%)" indicates the ratio (mass%) of the sintering aid in the raw materials, and "Fiber Addition Amount (mass%)" indicates the ratio (mass%) of fibrous aluminum nitride single crystals in the raw materials. "Holding Temperature (°C)" refers to the holding temperature (sintering temperature) during the sintering process, and "Holding Time (hours)" refers to the duration (sintering time) at which the holding temperature (sintering temperature) was maintained during the sintering process.

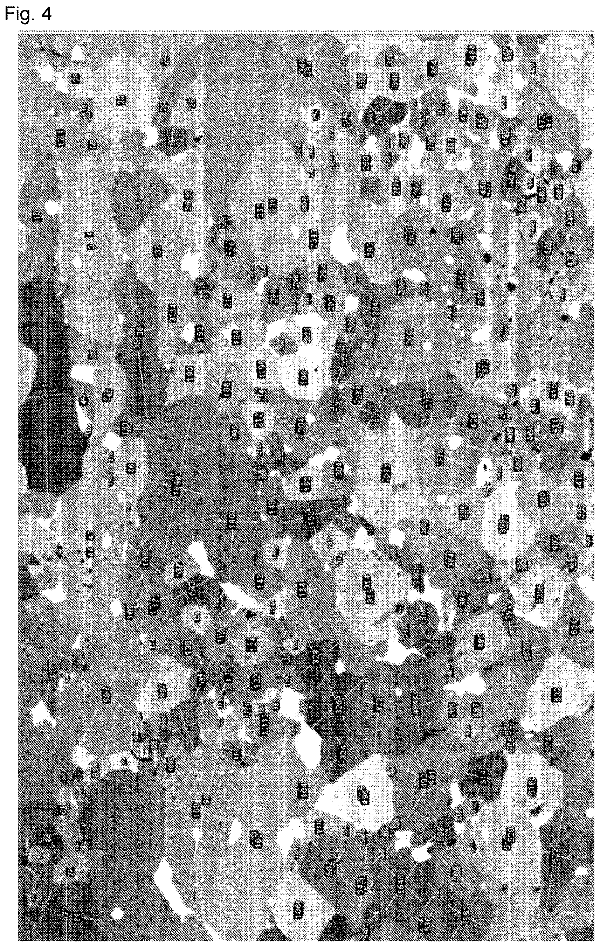

Furthermore, "Density (g/cm³)" in the table represents the density of the ceramic substrate, measured by the method described above. "Thermal Conductivity (W/m·K)" represents the thermal conductivity of the ceramic substrate, also measured as described above. "Fracture Toughness (MPa·m^{1/2})" represents the fracture toughness of the ceramic substrate, with the measurement method as previously described. Regarding the measurement direction for fracture toughness, it was measured so that the direction was perpendicular to one orientation of the cross-oriented fibers (formed during the forming process) and parallel to the other. "Flexural Strength (MPa)" represents the flexural strength of the ceramic substrate, measured as described above. "Oxygen Content (mass%)" indicates the amount of oxygen contained in the ceramic substrate, measured by the method described above. "Maximum Pore Diameter (µm)" refers to the largest value among the longest distances within each individual pore present in the aluminum nitride sintered body that makes up the ceramic substrate. "Maximum Short Diameter (µm)" refers to the maximum minor axis of the aluminum nitride particles comprising the aluminum nitride sintered body. The method by which the "micrograph of the aluminum nitride sintered body" is obtained, which is used to determine the longest distance of the voids and the maximum minor axis of aluminum nitride particles in the aluminum nitride sintered body, is as described above. Figure 4 shows the micrograph of the aluminum nitride sintered body for Sample No. 2.

Sample No. 1 is a ceramic substrate produced without using fibrous aluminum nitride single crystals. While it demonstrates a high flexural strength, it shows low thermal conductivity and fracture toughness. Samples No. 2 through No. 8 are ceramic substrates comprising an aluminum nitride sintered body formed by sintering fibrous aluminum nitride single crystals together with particulate aluminum nitride; these exhibit excellent thermal conductivity and fracture toughness. In particular, Samples No. 2, No. 7, and No. 8, by adjusting the maximum minor axis of the aluminum nitride particles in the sintered body to 15.0 µm, achieved superior flexural strength compared to Samples No. 3 to No. 6.

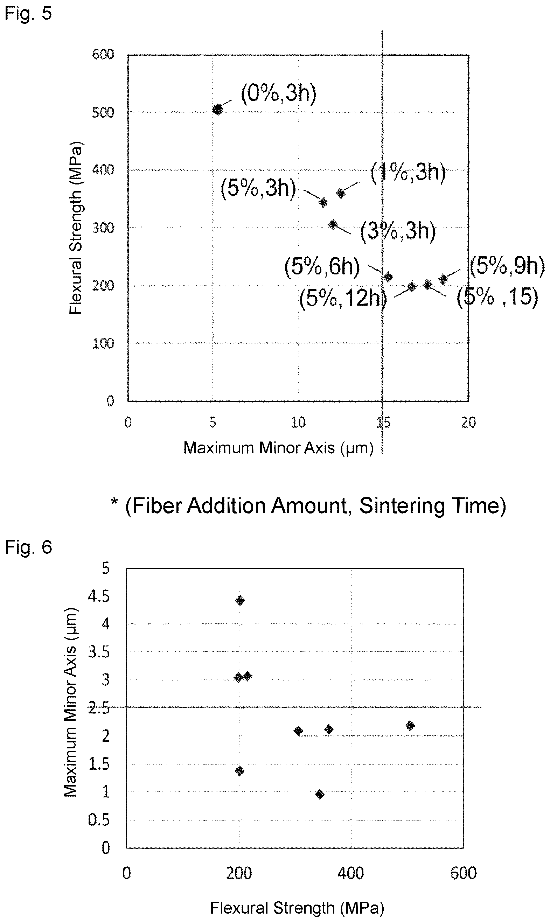

Figure 5 is a graph plotting the "Flexural Strength (MPa)" values from Table 1 on the vertical axis against the "Maximum Short Diameter (µm)" values on the horizontal axis for Samples No. 1 to No. 8. Each plot further includes annotations for "Fiber Addition Amount (mass%)" and "Holding Time (hours)" (*i.e.*, the sintering time).

Figure 6 is a graph plotting the "Maximum Pore Diameter (µm)" values from Table 1 on the vertical axis versus the "Flexural Strength (MPa)" values on the horizontal axis, showing the measurement results for Samples No. 1 through No. 8.

Next, a cold-heat cycle test was conducted using a compact tester (TSE-12-A) manufactured by Espec Corporation. The test conditions were set with a maximum temperature of 150 °C and a minimum temperature of -55 °C, and 1200 cycles of the cold-heat cycle test were performed.

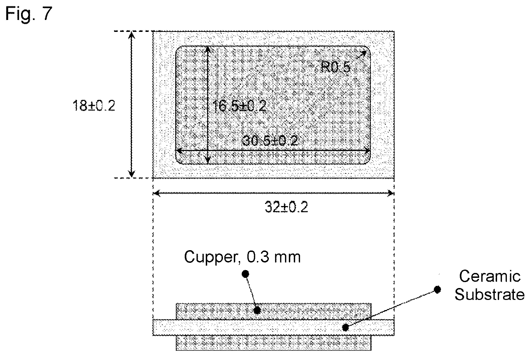

For the cold-heat cycle test, samples were prepared by bonding copper to both surfaces of the ceramic substrate in the plate thickness direction. Figure 7 shows a schematic diagram, and the dimensions of the sample used for the cold-heat cycle test. The corners of the copper foil were rounded with a radius of 0.5 mm. Except for thickness, the dimensions of the ceramic substrate and copper are given in millimeters.

The following ceramic substrates were used:
Ceramic substrate with added fibrous AlN single crystals (thickness: 0.635 mm)
AlN ceramic substrate manufactured by MARUWA (thickness: 0.635 mm)
SiN ceramic substrate manufactured by MARUWA (thickness: 0.32 mm)

The manufacturing method for the ceramic substrate containing fibrous AlN single crystals is as follows. After the kneading process with particulate aluminum nitride, the resulting slurry was granulated by spray drying. The obtained granulated powder was placed into a mold and pressed using a press machine to form a plate-shaped green body. This green body was further subjected to cold isostatic pressing (CIP) at 200 MPa for 1 minute to obtain a compact. The obtained compact underwent the degreasing and firing processes described above in "4. Degreasing Process" and "5. Firing Process," respectively, thereby yielding the ceramic substrate. For the obtained ceramic substrate, the maximum minor axis of the aluminum nitride particles was 15.0 µm or less.

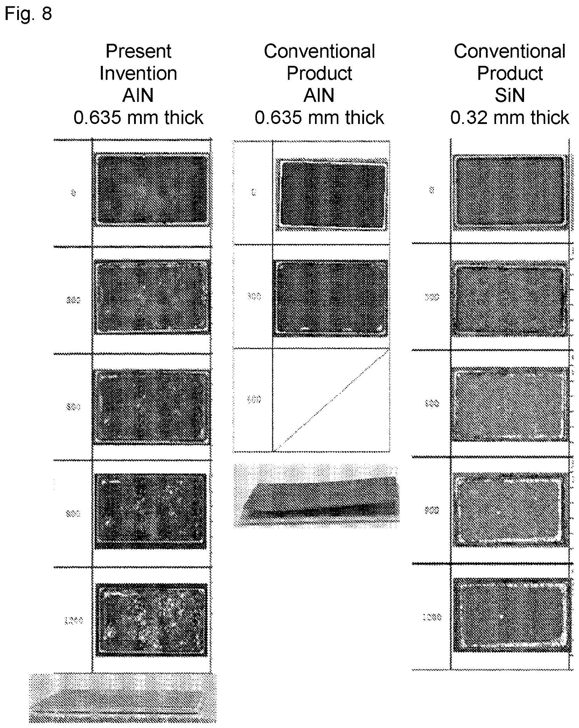

The results of the cold-heat cycle test are shown in Figure 8.

In Figure 8, "Present Invention / AlN / 0.635 mm thick" refers to the cold-heat cycle test results for the ceramic substrate containing the fibrous AlN single crystals. "Conventional Product / AlN / 0.635 mm thick" shows the result for a sample using an AlN ceramic substrate manufactured by MARUWA (Conventional Product A), and "Conventional Product / SiN / 0.32 mm thick" shows the result for a sample using a SiN ceramic substrate manufactured by MARUWA (Conventional Product B).

In Figure 8, for the "Present Invention / AlN / 0.635 mm thick," the SAT images (ultrasonic flaw detection images) of the sample are shown before the test, and after 300, 600, 900, and 1200 cycles, along with a photograph of the sample after 1200 cycles. For "Conventional Product / AlN / 0.635 mm thick," SAT images are shown for the samples before the test and after 300 cycles, and a photograph after 600 cycles. For "Conventional Product / SiN / 0.32 mm thick," SAT images are shown for the samples before the test, and after 300, 600, 900, and 1200 cycles.

Note that in Figure 8, the white areas in the SAT images or images captured by the ultrasonic flaw detector indicate delamination between the copper foil and the ceramic substrate.

The ceramic substrate containing fibrous AlN single crystals (present invention) did not fail even after 1200 cycles of the cold-heat cycle test. In contrast, in the conventional product A using the same AlN ceramic substrate, failure occurred after 600 cycles.

## Claims

1. A ceramic substrate comprising an aluminum nitride sintered body formed by sintering fibrous aluminum nitride single crystals and particulate aluminum nitride, wherein the maximum minor axis of the aluminum nitride particles comprising the sintered bodies 15.0 µm or less as determined from a micrograph of the sintered body.

2. The ceramic substrate according to Claim 1, wherein for each void present within the sintered body, the longest straight-line distance between any two points on the outer perimeter of the void in the micrograph of the sintered bodies is 2.5 µm or less.

3. The ceramic substrate according to Claim 1, wherein the thermal conductivity of the ceramic substrate is from 175 to 183 W/mK.

4. The ceramic substrate according to Claim 1, wherein, in at least one fracture direction measured by the SEPB method, the fracture toughness of the ceramic substrate is from 4.2 to 5.8 MPa·m^{1/2}.

5. The ceramic substrate according to Claim 1, wherein the flexural strength of the ceramic substrate is from 306 to 344 MPa.

6. The ceramic substrate according to Claim 1, wherein the thermal conductivity is from 175 to 183 W/mK, the fracture toughness is from 4.2 to 5.8 MPa·m^{1/2}, in at least one fracture direction measured by the SEPB method, and the flexural strength is from 306 to 344 MPa.

7. The ceramic substrate according to Claim 1, wherein the oxygen content in the ceramic substrate is 2.8 mass% or less.

8. A power module comprising the ceramic substrate according to any one of Claims 1 to 7.

9. An aluminum nitride sintered body formed by sintering fibrous aluminum nitride single crystals and particulate aluminum nitride, wherein the maximum minor axis of the aluminum nitride particles comprising the sintered body is 15.0 µm or less as determined from a micrograph of the sintered body.
